# EUROPEAN PATENT SPECIFICATION

(11) **EP 1 242 339 B1**
(45) Date of publication and mention of the grant of the patent: **29.07.2009**
(21) Application number: 00977289.8
(22) Date of filing: 29.09.2000
(51) Int. Cl.: C07B 61/00, G01R 33/46

(54) **METHODS FOR CREATING A COMPOUND LIBRARY AND IDENTIFYING LEAD CHEMICAL TEMPLATES AND LIGANDS FOR TARGET MOLECULES**
VERFAHREN ZUR HERSTELLUNG EINER VERBINDUNGSBIBLIOTHEK UND IDENTIFIZIERUNG VON LEAD CHEMISCHEN TEMPLATEN UND LIGANDEN VON ZIELMOLEKÜLEN
PROCEDES DE CREATION D'UNE BANQUE DE COMPOSES ET D'IDENTIFICATION DE MODELES CHIMIQUES PRINCIPAUX, ET DE LIGANDS DESTINES A DES MOLECULES CIBLES

(30) Priority: 29.09.1999 US 156818 P; 26.10.1999 US 161682 P; 28.03.2000 US 192685 P
(43) Date of publication of application: 25.09.2002
(73) Proprietor: Nerviano Medical Sciences S.r.l., 20014 Nerviano (MI) (IT)
(72) Inventor: STOCKMAN, Brian, J., Kalamazoo, MI 49008 (US); FARLEY, Kathleen, Otsego, MI 49078 (US); DALVIT, Claudio, Milano 20154 (IT)
(74) Representative: Perry, Robert Edward
(86) International application number: PCT/US2000/041034
(87) International publication number: WO 2001/023330

(56) References cited:
- EP-A- 0 592 816
- WO-A-97/00244
- WO-A-97/18471
- WO-A-98/46548
- WO-A-98/57155
- WO-A-99/09024
- WO-A-99/36422
- WO-A-99/43643
- GB-A- 2 316 941
- GB-A- 2 321 104
- US-A- 4 719 582
- US-A- 5 668 734
- US-A- 5 856 496
- FECIK R A ET AL: "THE SEARCH FOR ORALLY ACTIVE MEDICATIONS THROUGH COMBINATORIAL CHEMISTRY" MEDICINAL RESEARCH REVIEWS, NEW YORK, NY, US, vol. 18, 1998, pages 149-185, XP001010073 ISSN: 0198-6325 cited in the application
- TEAGUE S J: "The design of leadlike combinatorial libraries" ANGEWANDTE CHEMIE. INTERNATIONAL EDITION, VERLAG CHEMIE. WEINHEIM, DE, vol. 38, no. 24, 1999, pages 3743-3748, XP002170786 ISSN: 0570-0833 cited in the application
- FEJZO J ET AL: "THE SHAPES STRATEGY: AN NMR-BASED APPROACH FOR LEAD GENERATION IN DRUG DISCOVERY" CHEMISTRY AND BIOLOGY, CURRENT BIOLOGY, LONDON, GB, vol. 6, 16 September 1999 (1999-09-16), pages 755-769, XP000985859 ISSN: 1074-5521 cited in the application
- SHUKER S B ET AL: "Discovering High-Affinity Ligands for Proteins: SAR by NMR" SCIENCE, AMERICAN ASSOCIATION FOR THE ADVANCEMENT OF SCIENCE,, US, no. 274, 1996, pages 1531-1534, XP002074440 ISSN: 0036-8075
- MARTIN E J ET AL: "Beyond mere diversity: tailoring combinatorial libraries for drug discovery" JOURNAL OF COMBINATORIAL CHEMISTRY, AMERICAN CHEMICAL SOCIETY, WASHINGTON, US, vol. 1, 1999, pages 32-45, XP002170787 ISSN: 1520-4766
- WARR W A: "COMBINATORIAL CHEMISTRY AND MOLECULAR DIVERSITY. AN OVERVIEW" JOURNAL OF CHEMICAL INFORMATION AND COMPUTER SCIENCES, AMERICAN CHEMICAL SOCIETY, COLOMBUS,OHIO, US, vol. 37, no. 1, 1997, pages 134-140, XP000765620 ISSN: 0095-2338

## Description

### Background of the Invention

From an organic chemistry standpoint, the process of drug design can be considered to involve two steps. First, a lead chemical template (often one or more) is selected. Second, a synthetic chemistry effort is undertaken to create analogs of the lead chemical template to create a compound or compounds possessing the desired therapeutic and pharmacokinetic properties.

An important step in the drug discovery process is the selection of a suitable lead chemical template upon which to base a chemistry analog program. The process of identifying a lead chemical template for a given molecular target typically involves screening a large number of compounds (often more than 100,000) in a functional assay, selecting a subset based on some arbitrary activity threshold for testing in a secondary assay to confirm activity, and then assessing the remaining active compounds for suitability of chemical elaboration.

This process can be quite time- and resource-consuming, and has numerous disadvantages. It requires the development and implementation of a high-throughput functional assay, which by definition requires that the function of the molecular target be known. It requires the testing of large numbers of compounds, the vast majority of which will be inactive for a given molecular target. It leads to the depletion of chemical resources and requires the continual maintenance of large collections of compounds. Importantly, it often leads to a final pool of potential lead templates that, for the most part, with the exception of affinity for a given molecular target, do not possess desirable drug-like qualities. In some cases, high-throughput functional assays do not identify any compounds, from the large number (e.g. 100,000) of compounds screened, that meet the criteria established for activity.

WO98/57155 discloses a method of identifying a compound that binds to a target molecule, comprising the steps of:
providing a mixture of test compounds;
introducing the target molecule into a sample reservoir containing a mixture of test compounds, to provide a test sample; collecting a relaxation-filtered NMR spectrum on the sample; and
comparing the spectrum of this sample to the spectrum taken under the same conditions in the absence of the target molecule, to identify a compound that binds to the target molecule;
wherein the concentration of target molecule and each compound in each sample may be no more than 100 mM.

### Summary of the Invention

The present invention is related to rational drug design. Specifically, the present invention provides an approach to the development of a library of compounds as well as methods for identifying compounds (e.g. ligands) that bind to a specific target molecule (e.g., a protein) and lead chemical templates that can be used, for example, in drug discovery and design. This approach for identifying ligands for target molecules (e.g., proteins) uses nuclear magnetic resonance (NMR) spectroscopy. There are numerous NMR spectroscopic techniques currently available that detect binding of small molecules to targets such as protein targets, including targets identified using genomics techniques that lack a functional assay. Ligands with only moderate binding affinities, which might be overlooked in a traditional functional assay but yet might serve as templates for subsequent synthetic chemistry efforts, can potentially be identified using the present invention. The present invention involves the use of flow NMR techniques, which can reduce the amount of time and effort required to evaluate small molecules for binding to a given target.

According to the present invention, in a method of identifying a compound that binds to a target molecule, the method comprises:
selecting a library of test compounds each having a solubility in deuterated water of at least 1 mM at room temperature and a molecular weight of no greater than 350 grams/mole;
providing a plurality of mixtures of the test compounds, each mixture being in a sample reservoir;
introducing a target molecule into each sample reservoir, to provide a plurality of test samples;
providing a nuclear magnetic resonance spectrometer equipped with a flow injection probe;
transferring each test sample from the sample reservoir into the flow-injection probe;
collecting a WaterLOGSY nuclear magnetic resonance spectrum on each sample in each reservoir; and
analysing the spectrum of each sample to distinguish binding compounds from non-binding compounds, by virtue of the opposite signs of their water-ligand nuclear Overhauser effects;
wherein the concentration of target molecule and each test compound in each sample reservoir is no greater than 100 mM and wherein the ratio of target molecule to each test compound in each sample reservoir is no more than 1:1.

Preferably, the library of test compounds includes at least about 75 compounds, more preferably at least about 300 compounds, and most preferably at least about 2000 compounds, and these compounds preferably have relatively diverse chemical structures. Herein, the molecular weights of the compounds are determined without solubilising counterions (if the compounds are salts) and without water molecules of hydration. Also, concentrations are reported based on aqueous solutions, which may or may not include a buffer.

When binding is detected using the WaterLOGSY (water-ligand observation with gradient spectroscopy) technique, extremely low levels of target can be used, with a ratio of ligand to target that is preferably 100:1 to about 10:1. Preferably, the concentration of target molecule is no greater than about 10 mM. More preferably, the concentration of target molecule is about 1 mM to 10 mM. For data analysis, binding compounds are distinguished from nonbinders (i.e. non-binding compounds) by the opposite sign of their water-ligand NOEs. Using this method, there is no need to collect a reference spectrum in the absence of a target molecule.

The compounds in the library have a solubility in deuterated water of at least about 1 mM at room temperature (i.e., about 25°C to about 30°C), and a molecular weight of no greater than about 350 grams/mole. For effective use of a compound identified as a ligand for a given target in the search for a lead chemical template, preferably, the dissociation constant of the identified ligand to a target molecule is no weaker than (i.e., at least) 100 mM. For effective use of a lead chemical template in further drug design, preferably, the dissociation constant for the lead chemical template to a target molecule is no weaker than (i.e., at least) 1 mM.

### Brief Description of the Drawings

Figure 1. Schematic diagram illustrating the use of NMR to discover a ligand having an approximate dissociation constant of 1.0 x 10⁻⁴ M (left figure), to use the discovered ligand to direct the discovery of a lead chemical template having an approximate dissociation constant of 1.0 x 10⁻⁶ M (middle figure), and then via synthetic chemistry and structure-directed drug design arrive at a drug candidate having an approximate dissociation constant of 1.0 x 10⁻⁸ M.
Figure 2. Comparison of the two-dimensional HA (hydrogen-bond acceptor) vs. CHRG (charge) BCUT plots for the compounds contained in the NMR library described herein (dark squares) and a larger chemical library database (gray spots).
Figure 3. Schematic of the BEST flow system: (1) computer workstation, (2) NMR console, (3) Gilson sample handler, (4) flow probe in the magnet, and (5) nitrogen gas. The Gilson sample handler is labeled as follows: (A) keypad, (B) syringe, (C) injector, (D) solvent reservoir, (E) solvent rack, (F) sample racks, (G) waste reservoir, (H) Rheodyne valves, (I) injection port, and (J) recovery unit.
Figure 4. Schematic of a Bruker flow probe showing (A) the total probe volume, (B) the flow cell volume, and (C) the positioning volume.
Figure 5. 600.13 MHz ¹H NMR spectra of a 100 µM NMR library sample with the positioning volume set to (A) -100 µl, (B) 0 µl, and (C) +100 µl.
Figure 6. Overlay of the two-dimensional HA (hydrogen-bond acceptor) vs. CHRG (charge) BCUT plots for the compounds in the CMC index (gray) and the lead-like compounds contained therein (black).
Figure 7. Region of the 600.13 MHz WaterLOGSY spectrum of a compound mixture with added target protein. The concentration of protein was 10 µM while the concentration of each compound was 100 µM. The spectrum was acquired on a Bruker 5 mm flow-injection probe at 27°C. A total of 4K scans were collected resulting in a total acquisition time of about 288 minutes. A mixing time of 2.0 seconds was used.

### Detailed Description of Preferred Embodiments of the Invention

The present invention involves the selection of a generally small library of structurally diverse compounds that are generally water soluble, have a relatively low molecular weight, and are amenable to synthetic chemistry elaboration. Significantly and advantageously, for certain embodiments, the present invention preferably involves carrying out a binding assay at relatively low concentrations of target and near equimolar ratios of ligand to target, or even at extremely low concentrations of target and higher ratios of ligand to target.

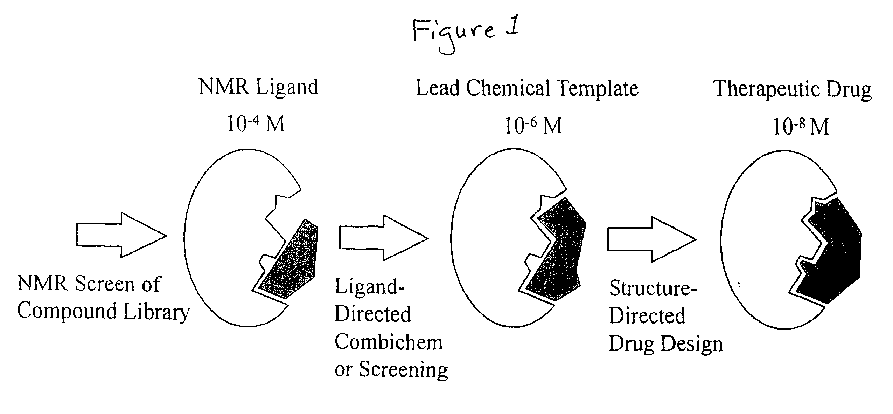

In a method of the present invention, a relatively small subset of compounds (preferably, at least about 75, more preferably, at least about 300, most preferably, at least about 2000, and typically no more than about 10,000) that mimics the structural diversity of compounds in much larger collections is created based on a predetermined set of criteria. This generally small library is screened for binding affinity to a target molecule (as determined herein by dissociation constants). The compounds from the library that are identified to be effective ligands (typically, having an affinity for a desired target as evidenced by a dissociation constant of at least about 1.0 x 10⁻⁴ M) are then used to focus further screening efforts or to direct chemical elaborations to arrive at one or more lead chemical templates (which, typically have an affinity for a desired target as evidenced by a dissociation constant of at least about 1.0 x 10⁻⁶ M). This process is shown schematically in Figure 1.

Significantly, time and resources are saved by screening far fewer compounds using the present invention. Use of a binding assay, such as the one based on NMR spectroscopy described herein, eliminates the need to develop a high-throughput functional assay, and also allows the methods to be used on molecular targets lacking a known function.

Thus, the present invention provides methods of identifying a compound that binds to a target molecule (preferably, a protein) that are based on NMR spectroscopy techniques, using WaterLOGSY. This involves the transfer of magnetization from bulk water to detect the binding interaction. Using WaterLOGSY techniques, binding compounds are distinguished from nonbinders by the opposite sign of their water-ligand nuclear Overhauser effects (NOEs).

Important elements that contribute to the success of the methods of the invention preferably include developing a suitable small library of compounds to screen, carrying out the binding assay at extremely low concentrations of target (if desired) and high ratios of ligand to target, and the capacity for rapid throughput of data collection. For example, the concentration of target molecule is preferably no greater than about 10 µM.

The selection of compounds in a small library (preferably, at least about 75 compounds, more preferably, at least about 300 compounds, and most preferably, at least about 2000 compounds) is important in that its diversity should mimic the diversity of larger compound collections. Preferably, each component possesses many of the desirable qualities of a lead chemical template. These include water solubility, low molecular weight (no greater than about 350 grams/mole, more preferably, no greater than about 325 grams/mole, and most preferably, less than about 325 grams/mole), and amenability to synthetic chemistry elaboration. Templates possessing these qualities, as compared to a template selected randomly, are preferably considered to be predisposed to being lead-like and having an increased likelihood of ultimately leading to a drug.

Good structural diversity in a library increases the likelihood that one or more compounds will possess structural characteristics important for binding to a given molecular target. Predisposing the compounds to be water soluble, to have low molecular weight (no greater than about 350 grams/mole, more preferably, no greater than about 325 grams/mole, and most preferably, less than about 325 grams/mole), and to be amenable to synthetic elaboration increases the likelihood that a compound found to be a ligand will lead to a related compound or compounds suitable as a lead chemical template for use, for example, in a process of identifying an effective therapuetic and/or prophylactic agent. Additionally, the requirement for good water solubility (at least about 1.0 x 10⁻³ M in deuterated water at room temperature) is important in that it increases the likelihood of success of other downstream drug-design projects, such as co-crystallization attempts, calorimetry studies, and enzyme kinetic analyses.

Compounds testing positive for binding have affinities within a factor of about 3-4 of low target concentrations (preferably, no greater than about 10 µM, but is more preferably about 1 µM to about 10 µM) and ligand to target ratios of about 100:1 to about 10:1. This level of affinity is desired if the subsequent steps of focused screening and directed chemical elaboration are to be successful in elucidating a lead chemical template with very low affinity (e.g., one having a dissociation constant of at least about 1.0 x 10⁻⁶ M). Carrying out the initial screening at these low concentrations also avoids detection of unwanted compounds with much smaller dissociation constants in the 1.0 x 10⁻³ M range, which are less specific in their binding and therefore harder to turn into lead chemical templates given their weak affinity initially.

The capacity for rapid throughput of data collection is important if a large number of molecular targets are to be screened. Flow NMR techniques can reduce the amount of time and effort required to evaluate small molecules for binding to a given target. For example, the use of a Bruker Efficient Sample Transfer system in combination with a tubeless, flow-injection NMR probe has proven to be much faster and less labor intensive than the use of traditional NMR tubes. A significant increase in throughput is obtained compared to both manual sample changing and to using an autosampler. Implementation of the screening process using multiwell sample holders also standardizes the experimental setup as well as the components in a given mixture from one molecular target to the next.

The following is a description of a preferred method for carrying out the present invention. It is provided for exemplification purposes only and should not be considered to unnecessarily limit the invention as set forth in the claims.

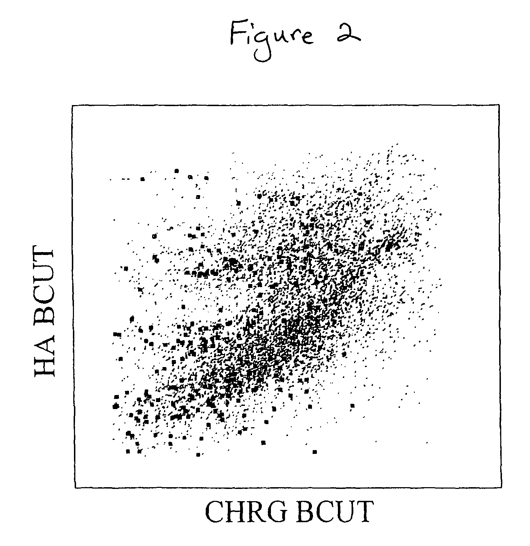

In the design of a preferred small library of structurally diverse compounds according to the present invention, compounds were selected from a large library based on dissimilarity, predicted water solubility, low molecular weight, and chemical intuition. Some were based on frameworks suggested in the literature, although some literature-suggested frameworks were consciously avoided. Each compound was tested for solubility at 1.0 x 10⁻³ M in ²H₂O and for purity by mass spectrometry and ¹H NMR spectroscopy. Compounds deemed to be water soluble and pure were kept for inclusion in the final library (approximately 30% of the initial compounds). The resulting library contains approximately 300 compounds. One measure of the degree of structural diversity of the compounds in this small library is shown in Figure 2. This is based on the technique described in Pearlman et al., *Perspectives in Drug Discovery & Design*, **9**, 339-353 (1998). Preferably, the compound library includes compounds of sufficiently diverse chemical structure that one would expect at least one compound to bind to a given target protein with an affinity (dissociation constant) no weaker than (i.e., at least) about 200 µM. Herein, compounds of diverse chemical structure are those that have a variety of backbone hydrocarbon structures (e.g., linear, branched, cyclic - which may or may not be aromatic, have fused rings, etc.), optionally including a variety of heteroatoms (e.g., oxygen, nitrogen) and a variety of functional groups (e.g., carbonyls) in a variety of positions (e.g., pointing in various directions at a variety of distances from each other). Ideally, using the technique described in Pearlman et al., *Perspectives in Drug Discovery & Design*, **9**, 339-353 (1998), the library of compounds displays a pattern of well-dispersed black squares (e.g., see Figure 2).

In order to increase the throughput of the NMR screening, compounds were grouped into 32 sets of 6-10 compounds that have at least one distinguishable resonance in a 1D ¹H NMR spectrum of the mixture. To accomplish this, a 1D ¹H NMR spectrum was obtained of each mixture in 100% ²H₂O and in 0.1 M sodium phosphate/100% ²H₂O at pH 6.5. Two solvents were used in order to determine the assignment of pH-titratable resonances in the spectrum. Each of the 32 mixtures was then plated out into separate wells of a 96-well plate, using 25 µL of a 1.0 x 10⁻³ M solution, and frozen at -80°C until needed. In an initial version of the NMR screening library, approximately 70 compounds were grouped into 21 sets of 3-4 compounds each.

After a 96-well plate had completely thawed, a solution containing a molecular target protein was added to each well containing a mixture of compounds in the 96-well plate. The final concentration of protein is typically about 5.0 x 10⁻⁵ M. The ratio of each compound in a mixture to protein is typically about 1:1. This process typically involves adding 475 mL of protein to each mixture. Dispersion throughout the mixture was facilitated by shaking the 96-well plate for 20 minutes following addition of protein.

WaterLOGSY methods are used to detect the binding interaction. WaterLOGSY is described in more detail in C. Dalvit et al., J. Biomol. NMR, 18, 65-68 (2000).

Since WaterLOGSY relies on the transfer of magnetization from bulk water to detect the binding interaction, it is a very sensitive technique. As such, the concentration of target molecule (e.g., protein) in each sample preferably can be reduced to no greater than about 10 µM (preferably, about 1 µM to about 10 µM) while the concentration of each compound can be about 100 µM. This results in ratios of target molecule to compounds in each sample reservoir of about 100:1 to about 10:1. The exact concentrations and ratios used can vary depending on the size of the target molecule, the amount of target molecule available, the desired binding affinity detection limit, and the desired speed of data collection. In contrast to the relaxation-editing method, there is no need to collect a comparison or control spectrum to identify binding compounds from nonbinders. Instead, binding compounds are distinguished from nonbinders by the opposite sign of their water-ligand nuclear Overhauser effects (NOEs).

Ligand binding was confirmed by making fresh solutions containing only the identified ligand, with and without added protein at a 1:1 ratio, and comparing the 1D relaxation-edited ¹H NMR spectra. In addition, the ligand's dissociation constant was estimated by analyzing several 1D diffusion-edited ¹H NMR spectra collected at several gradient strengths. The relative diffusion coefficients for the protein, for the ligand in the presence of protein, and for the ligand in the absence of protein, in conjunction with known protein and ligand concentrations, were used to estimate the ligand's dissociation constant. These spectra are typically collected using an NMR spectrometer, a conventional high resolution probe, and regular 5 mm NMR tubes.

Once a ligand had been identified and confirmed, its structure is used to identify available compounds with similar structures to be assayed for activity or affinity, or to direct the synthesis of structurally related compounds to be assayed for activity or affinity. These compounds are then either obtained from inventory or synthesized. Most often, they are then assayed for activity using enzyme assays. In the case of molecular targets that are not enzymes or that do not have an enzyme assay available, these compounds can be assayed for affinity using NMR techniques similar to those described above, or by other physical methods such as isothermal denaturation calorimetry. Compounds identified in this step with affinities for the molecular target of about 1.0 x 10⁻⁶ M are typically considered lead chemical templates.

In some instances, ligand binding is further studied using more complex NMR experiments or other physical methods such as calorimetry or X-ray crystallography. These downstream studies have a greater chance of success since the ligands and lead chemical templates so identified are fairly water soluble. For instance, if [¹⁵N]protein is available, 2D ¹H-¹⁵N HSQC (heteronuclear single quantum correlation) spectra can be collected with and without added ligand to locate the ligand's binding site on the protein. In cases where the protein is small enough (molecular weight less than about 30,000) and further characterization of protein/ligand interactions is desired, 3D NMR experiments can be carried out on [¹³C/¹⁵N]protein/[¹²C/¹⁴N]ligand complexes. Attempts to soak lead chemical templates identified by this method into existing protein crystals, or to form co-crystals, can also be carried out.

### Examples

Objects and advantages of this invention are further illustrated by the following examples, but the particular materials and amounts thereof recited in these examples, as well as other conditions and details, should not be construed to unduly limit this invention, which is defined in the claims.

### Introduction to Flow-Injection NMR Spectroscopy

Flow NMR spectroscopy techniques are becoming increasingly utilized in drug discovery and development (B. J. Stockman, Curr. Opin. Drug Disc. Dev., 3, 269-274 (2000)). The technique was first applied to couple the separation characteristics of liquid chromatography with the analytical capabilities of NMR spectroscopy (N. Watanabe et al., Proc. Jpn. Acad. Ser B, 54, 194 (1978)). Since then, HPLC-NMR, or LC-NMR as it is more commonly referred to, has been broadly applied to natural products biochemistry, drug metabolism and drug toxicology studies (J. C. Lindon et al., Prog. NMR Spectr., 29, 1 (1996); J. C. Lindon et al., Drug. Met. Rev., 29, 705 (1997); B. Vogler et al., J Nat. Prod., 61, 175 (1998); and J.-L. Wolfender et al., Curr. Org. Chem. 2, 575 (1998)). The wealth and complexity of data made available from the latter two applications have created the potential for NMR-based metabonomics to complement genomics and proteomics (J. K. Nicholson et al., Xenobiotica, 29, 1181 (1999)). Stopped-flow analysis in LC-NMR, where the chromatographic flow is halted to obtain an NMR spectrum with higher signal-to-noise and then restarted when the spectrum has finished collecting, was the forerunner to the flow-injection systems that will be described here. The largest difference between the two systems is that one includes a separation component (LC column) and the other does not. The rapid throughput possible for combinatorial chemistry samples and protein/small molecule mixtures has allowed flow-injection NMR methods to impact medicinal chemistry and protein screening (P. A. Keifer, Drugs Fut., 23, 301 (1998); P. A. Keifer, Drug Disc. Today, 2, 468 (1997); P. A. Keifer, Curr. Opin. Biotech., 10, 34 (1999); K. A. Farley et al., SMASH'99, Argonne, IL, 15-18 August 1999; and A. Ross et al., Biomol. NMR, 16, 139 (2000)).

Changes in chemical shifts, relaxation properties or diffusion coefficients that occur upon the interaction between a protein and a small molecule have been documented for many years (for recent reviews see M. J. Shapiro et al., Curr. Opin. Drug. Disc. Dev., 2, 396 (1999); J. M. Moore, Biopolymers, 51, 221 (1999); and B. J. Stockman, Prog. NMR Spectr., 33, 109 (1998)). Observables typically used to detect or monitor the interactions are chemical shift changes for the ligand or isotopically-enriched protein resonances (J. Wang et al., Biochemistry, 31, 921 (1992)), or line broadening (D. L. Rabenstein, et al., J. Magn. Reson., 34, 669 (1979); and T. Scherf et al., Biophys. J., 64, 754 (1993)), change in sign of the NOE from positive to negative (P. Balaram et al., J. Am. Chem. Soc., 94, 4017 (1972); and A. A. Bothner-By et al., Ann. NY Acad. Sci. 222, 668 (1972)), or restricted diffusion (A. J. Lennon et al., Biophys., J. 67, 2096 (1994)) for the ligand. For the most part, these studies have focussed on protein/ligand systems where the small molecule was already known to be a ligand or was assumed to be one. In the last several years, however, the work of the Fesik (S. B. Shuker et al., Science, 274, 1531 (1996); and P. J. Hajduk et al., J. Am. Chem. Soc., 119, 12257 (1997)), Meyer (B. Meyer et al., Eur. J. Biochem., 246, 705 (1997)), Moore (J. Fejzo et al., Chem. Biol., 6, 755 (1999)), Shapiro (M. Lin et al., J. Org. Chem., 62, 8930 (1997)), and Dalvit (C. Dalvit et al., J. Biomol NMR, 18, 65-68 (2000)) labs has demonstrated the applicability of these same general methods as a screening tool to identify ligands from mixtures of small molecules.

These screening protocols typically involve the preparation of a series of individual samples in glass NMR tubes and the use of an autosampler to achieve reasonable throughput. Variations in volume or positioning that occur during sample preparation or tube insertion can necessitate tuning and calibration of the probe between each sample, thereby reducing throughput of data collection.

By contrast, flow-injection NMR has several advantages. The stationary flow cell provides uniform locking and shimming from one sample to the next, and, with the radio frequency coils mounted directly onto the flow cell's glass surface, high sensitivity. Fast throughput of data collection is thus possible. Use of a liquid handler to prepare and inject samples, such as the Gilson 215 liquid handler used on Bruker and Varian systems, allows the potential for on-the-fly sample preparation (A. Ross et al., J. Biomol. NMR, 16, 139 (2000)), thus maximizing sample integrity and uniformity. Since the use and/or re-use of glass NMR tubes is avoided, costs are minimized.

### Data Acquisition Hardware and Software

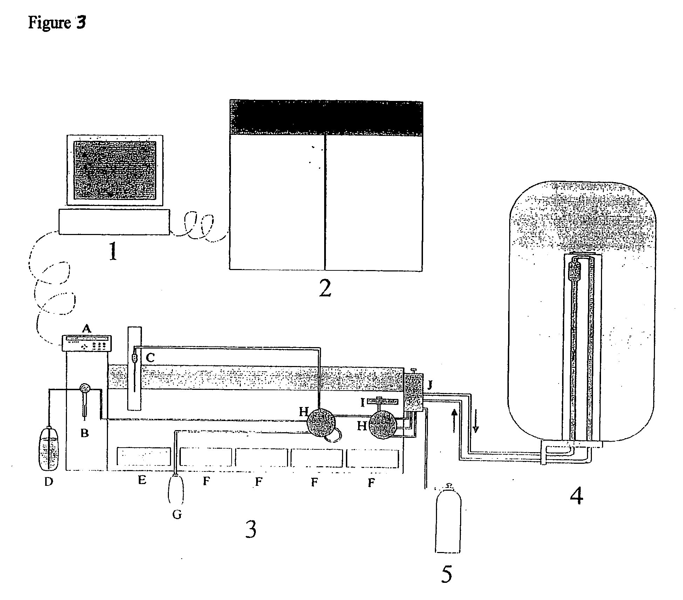

A typical Flow NMR system consists of a magnet, an NMR console, a computer workstation, a Gilson sample handler, and a flow-injection probe. Two vendors currently offer complete flow-injection systems: Bruker Instruments and Varian Instruments. In addition, the Nalorac Corporation manufactures an LC probe that can also be used for flow-injection NMR screening. A schematic of the Bruker Efficient Transport System (BEST) manufactured by Bruker Instruments is shown in Figure 3. The Gilson 215 sample handler supplied by Bruker is equipped with two Rheodyne 819 valves. The first valve is attached to a 5 ml syringe, the needle capillary in the sample handler injection arm, the bridge capillary, the waste reservoir, and the second valve. The second Rheodyne valve is attached to the input and output of the probe, the source of nitrogen gas, the first valve, and the injection port. FEP Teflon tubing is used in each of the connections with the exception of the gas connection, which uses PEEK tubing.

A sample is injected into the Bruker probe by filling the needle capillary and transferring the sample into the inlet tubing for the probe using the second Rheodyne valve. In quick mode, the next sample is loaded into the tubing during the spectral acquisition of the previous sample. When the spectral acquisition has completed, the first sample exits the probe through the outlet capillary. This action pulls the next sample into the probe through the inlet port and spectral acquisition can immediately begin. Quick mode acquisition can save approximately one minute per sample from the time it would take to load each sample individually. However, sample recovery is not currently an option with this method. In order to recover a sample, each sample is injected individually using normal mode acquisition. The sample is recovered by selecting either nitrogen gas or the syringe to pull the sample back from the probe through the inlet tube. The sample can then be returned to the Gilson liquid handler into its original well or into a new 96 well plate. A recovery unit has recently been added to the BEST system to improve the efficiency of recovery of the syringe by using the nitrogen gas to create a back pressure on the sample.

Two useful accessories available for the BEST system are a Valvemate solvent switcher and a heated transfer line. The solvent switcher was added to the flow system for the combinatorial chemist who may want to analyze samples in various organic solvents, but it can also be used for a library screen to vary buffer conditions or to clean the probe out with an acid or a base. The heated transfer line is used to equilibrate the sample temperature to the probe temperature during sample transfer. Both the inlet and output capillary transfer lines are threaded through the heated transfer line. This feature is desirable when the spectral analysis time is short and a high throughput of samples is required. In the ideal case, data acquisition using this accessory can begin immediately after the sample enters the probe. Some samples may still require a temperature equilibration period after entering the probe.

The setup of the Versatile Automated Sample Transport (VAST) system produced by Varian is similar to the Bruker system. The VAST system consists of a Gilson 215 liquid handler, a Varian NMR flow probe, an NMR console, and a Sun workstation. The Gilson liquid handler supplied by Varian is equipped with a single Rheodyne 819 valve and is connected to the NMR flow probe with 0.3 mm [0.010 inch] inside diameter PEEK tubing (P. A. Keifer et al., J. Comb. Chem., 2, 151 (2000)). In the Varian system design, the sample handler injects a specified volume of sample into the probe, the data is acquired, and then the flow of liquid through the tubing is reversed and the sample is returned to its original vial or well. The return of the sample to the Gilson by the syringe pump is assisted by a Valco valve and nitrogen gas which supply some backpressure on the outlet portion of the Varian flow probe. With the VAST system setup, the probe is rinsed just prior to sample injection and then is dried with nitrogen gas to minimize dilution of the sample during injection. The Varian design gives excellent sample recovery without dilution, but it is strongly recommended that samples be filtered to prevent clogging of the capillary transfer lines (P. A. Keifer et al., J. Comb. Chem., 2, 151 (2000)).

Flow NMR systems are ideally suited for use with the shielded magnets manufactured by Bruker Instruments or Oxford Magnets. Actively shielding a 600 MHz magnet reduces the radial 5 gauss line from approximately 4 meters to less than 2 meters, which allows the Gilson liquid handler to be placed significantly closer to the magnet. This reduces the length of tubing needed between the Rheodyne valve and the flow-injection probe and minimizes the sample transfer time. The potential for clogging and sample dilution are concomitantly reduced.

Bruker uses two software packages to run the BEST system: BEST Administrator and ICONNMR (Bruker Instruments, AMIX, BEST and ICONNMR software packages). The BEST administrator is activated by typing the command 'BESTADM' in XWINNMR. This portion of the software is used during method generation and optimization. Samples are injected into the probe one at a time and data is collected under XWINNMR. Early versions of the BEST software utilized three separate programs: CFBEST, SUBEST, and OTBEST. These functions were recently combined under the single software package, BEST Administrator. In addition, the parameters available for customization have been greatly expanded to include automated solvent switching and method switching, which were not available in earlier versions of the software. The software package ICONNMR is used after a flow method has been optimized with the BEST administrator. This package is setup for full automation and is the same software used with automated NMR tube sample changers. In a similar fashion, Varian software uses the command 'Gilson' to generate a method before sample injection and data acquisition is initiated using Enter/Autogo in VNMR (Varian NMR Systems, VNMR software package).

### Flow Probe Calibration and System Optimization

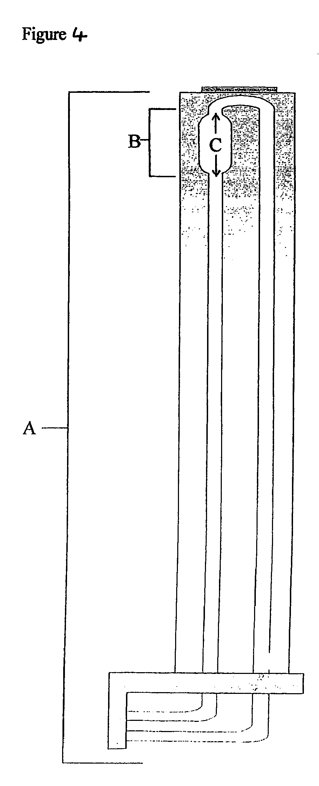

In addition to the normal 90° pulse lengths and power levels which are calibrated for any NMR probe, several additional calibrations are required for a flow probe. The three additional volumes required to calibrate a Bruker flow probe are shown schematically in Figure 4 (Bruker Instruments, AMIX, BEST and ICONNMR software packages). The first volume calibrated is the total probe volume. This can be accomplished by injecting a colored liquid into the inlet of a dry probe with a syringe and watching for the liquid to appear in the outlet port (approximately 700-800 µL for a 5 mm flow probe). With the Varian system, the system filling volume also includes the capillary tubing that connects the injector port to the flow probe (P. A. Keifer et al., J. Comb. Chem., 2, 151 (2000)). This volume is used to calculate the distance required to reposition a sample from the Gilson sample handler to the center of the flow cell in the probe.

The second volume calibrated is the flow cell volume. This is the volume of liquid required to fully fill the coil around the flow cell. The three flow probe vendors (Bruker, Varian, and Nalorac) have probes available with active volumes ranging from 30-250 µL. The stated volume of the flow cell in a 5 mm Bruker flow probe is 250 µL, but it was calibrated to be approximately 300 µL. This volume can be calibrated by making repeated injections of a standard sample, starting with a volume less than the stated active volume of the probe, and collecting a 1D ¹H NMR spectrum. The injection volume can then be increased incrementally until no further improvement in signal-to-noise is observed.

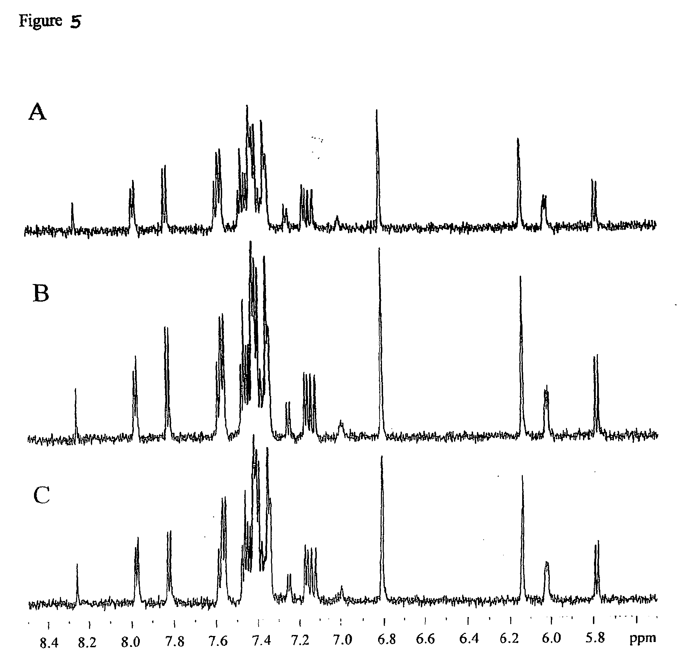

In addition to the two probe volume calibrations already discussed, Bruker software also includes a third volume for calibration. This volume, referred to as the positioning volume, is used to optimize the centering of a sample in the flow cell. Early versions of ICONNMR software (prior to 3.0.a.9) did not include the ability to set the positioning volume. Rather, Bruker literature suggested that the flow cell volume should be roughly doubled to insure that the sample would completely fill the coil (Bruker Instruments, AMIX, BEST and ICONNMR software packages). Fortunately, this is no longer necessary. The positioning volume can now be used to optimize the sample position. This calibration reduced the sample size required for injection from 450 µL in the first few protein screens to 300 µL for current screens using a Bruker 5 mm flow probe with an active volume of 250 µL. Optimization of this parameter minimized the sample volume required for each spectrum. Importantly, this significantly reduced the total amount of protein (or other target) at a given concentration needed to screen our small molecule library. The positioning volume can be optimized by collecting a series of spectra on a standard sample. In each spectrum collected, the positioning volume can first be varied by large increments (50-100 µL) to get a rough estimate of the volume. An example of three such spectra is shown in Figure 5. The positioning volume can then be varied in smaller increments (10-25 µL) to identify the best volume for this parameter. The best signal-to-noise was obtained for our 5 mm Bruker flow probe on a DRX-600 when the positioning volume was set to +25 µL, but this volume is probe specific and is calibrated for each flow probe.

The optimization of a flow-injection system for screening has three main objectives. The first objective is to transfer an aqueous sample to the center of the flow cell for analysis using the parameters determined during the flow probe calibration described above. The second objective is to reposition a sample from the Gilson liquid handler into the flow-injection probe without bubbles and with minimal sample dilution. This can be achieved by using nitrogen as a transfer gas (which keeps the system under pressure) and by using a series of leading and trailing solvents. In our experiments, we typically use 150 µL of ²H₂O as a leading solvent, 20 µL of nitrogen gas, 300 µL of sample, 20 µL of nitrogen gas, and 100 µL of ²H₂O as a trailing solvent. Alternatively, a larger volume of sample can be used in place of the push solvents. The third objective is to determine a cleaning procedure which would reduce sample carry-over to less than 0.1 %. Typically, this involves rinsing the probe with a predetermined volume of water. The rinse cycle can also be followed by a dry cycle, in which the capillary lines and flow probe are dried with nitrogen gas to further minimize sample dilution. In our experiments, we typically use a 1-mL wash volume followed by a 30 second drying time with nitrogen gas.

### Design of Small Molecule Screening Libraries

With the increasing prevalence of extremely high throughput screening equipment in the pharmaceutical industry, it may seem counter intuitive to suggest screening smaller collections of compounds in an NMR-based assay. However, a correlation between the quality of hits obtained and the number of compounds screened has not been well documented. In fact, compounds are typically added to screening collections not to simply increase their numbers, but to increase the diversity and quality of the compound collection. Thus, if one could find suitable hits from a smaller collection of well-chosen compounds, it may not be necessary to expend the time and chemical resources to screen the entire compound library against every single target. Hits so identified could then be used to focus further screening efforts or to direct combinatorial syntheses, thus saving both time and chemical resources, as shown schematically in Figure 1. An NMR-based screen, like other binding assays, has the advantage in that a high throughput functional assay does not need to be developed. This will become increasingly important as more and more targets of interest to pharmaceutical research are derived from genomics efforts and thus may not have a known function that can be assayed.

Several types of libraries are possible: broad screening libraries applicable to many types of target proteins, directed libraries that are designed with the common features of an active site in mind that might be useful for screening a series of targets from the same protein class, such as protease enzymes, and "functional genomics" libraries composed of known substrates, cofactors and inhibitors for a diverse array of enzymes that might be useful for defining the function of genomics-identified targets.

Ideally, the size and content of a broad screening library should be such that screening can be accomplished in a day or two with a favorable chance of identifying several hits for each of the target proteins to be screened. Rather than just randomly choosing a subset library, several rationale approaches have been implemented. These include the SHAPES library developed by Fejzo and coworkers that is composed largely of molecules that represent frameworks commonly found in known drug molecules (J. Fejzo et al., Chem. Biol., 6, 755 (1999)), drug-like or lead-like libraries, and diversity-based libraries. A number of studies have recently appeared that discuss the properties of known drugs and methods to distinguish between drug-like and non-druglike compounds (G. W. Bemis et al., J. Med. Chem., 39, 2887 (1996); C. A. Lipinski et al., Adv. Drug Del. Rev., 23, 3 (1997); Ajay et al., J. Med. Chem., 41, 3314 (1998); J. Sadowski et al., J. Med. Chem., 41, 3325 (1998); A. K. Ghose et al., J. Comb. Chem., 1, 55 (1999); J. Wang et al., J. Comb. Chem., 1, 524 (1999); and G. W. Bemis et al., J. Med. Chem., 42, 5095 (1999)). Superimposing drug-like (E. J. Martin et al., J. Comb. Chem., 1, 32 (1999)) or lead-like (S. J. Teague et al., Angew. Chem. Int. Ed., 38, 3743 (1999)) properties on a diversity-selected compound set may yield the best library of compounds. The distinction of lead-like is important since the NMR-based assay is designed to identify weak-affinity compounds that will most likely gain molecular weight and lipophilicity to become drug candidates or even lead chemical templates (S. J. Teague et al., Angew. Chem. Int. Ed., 38, 3743 (1999)).

Development and expansion of our lead-like NMR screening library to mimic the structural diversity of our larger compound collection has made use of the DiverseSolutions software for chemical diversity (R. S. Pearlman et al., Persp. Drug Disc. Des., 9/10/11, 339 (1998)). In this approach, each compound is described by a set of descriptors, which are metrics of chemistry space. Six orthogonal descriptors, related to substructures as opposed to the entire molecule, are often used. While the descriptors to use can be automatically chosen to maximize diversity, typically there are two each corresponding to charge, polarizability and hydrogen-bonding. A cell-based diversity algorithm is employed to divide the descriptor axes into bins and thus into a lattice of multidimensional hypercubes. As an example of how this can be used to construct or expand a small screening library, consider the selection of 1,000 compounds from a compound library of 250,000 compounds. First, the cell-based algorithm is used to partition the 250,000 compounds into approximately 1,000 cells. The number of compounds per cell will vary and some will be empty. Maximum structural diversity will be obtained by taking one compound from each occupied cell (and as close to the center as possible). The actual compounds chosen are based on desirable lead-like properties such as low molecular weight and hydrophilicity as well as availability and chemical non-reactivity as explained below. Diversity voids, as exemplified by empty cells, can be filled from external sources or by chemical syntheses if desired. Identifying and filling diversity voids is important since larger compound collections are often heavily weighted in certain classes of compounds stemming from earlier research projects.

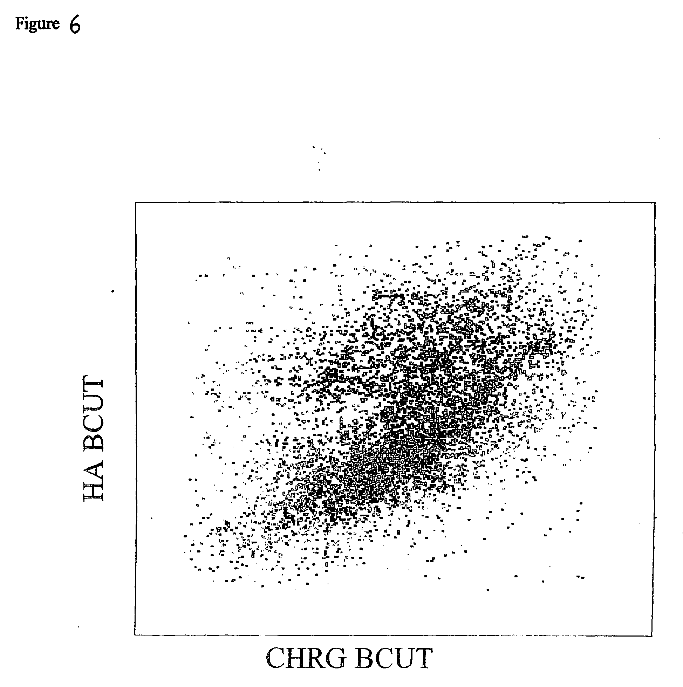

An example of diversity-based subset selection using these methods is shown in Figure 6. Here, the 6,436 compounds from the Comprehensive Medicinal Chemistry index have been divided into 2,012 cells to maximize diversity using five chemistry-space descriptors. The two-dimensional representation projected onto the hydrogen bond acceptor and charge BCUT axes is shown in gray. The black squares correspond to the 1,474 lead-like compounds (molecular weight less than 350 and 1 < cLogP < 3) contained in the CMC index. A total of 806 of the 2,012 cells were occupied by lead-like compounds. A similar approach could be used to select diverse, lead-like compounds from a large corporate compound collection.

The cell concept of structural space is quite useful after the screening is complete. When a hit is identified, other compounds from the same or nearby cells are obvious candidates for secondary assays. One can think of this as the gold mine analogy: when gold is struck, the search is best continued in close proximity.

In addition to structural diversity, there are other characteristics that can be considered when selecting the subset molecules. These include purity, identity, reactivity, toxicological properties, molecular weight, water solubility, and suitability for chemical elaboration by traditional or combinatorial methods. It makes sense to populate the screening library with compounds of high integrity that are not destined for failure down the road. Time spent upfront to insure purity and identity with LC-MS or LC-NMR analyses will save resources downstream. Filtering tools can be used to avoid compounds that are known to be highly reactive, toxic, or to have poor metabolic properties. Lack of reactivity is important since compounds can be screened more efficiently as mixtures. Like other labs (S. B. Shuker et al, Science, 274, 1531 (1996); B. Meyer et al., Eur. J. Biochem., 246, 705 (1997); J. Fejzo et al., Chem. Biol., 6, 755 (1999); and M. Lin et al., J. Org. Chem., 62, 8930 (1997)) we typically pool our selected small molecules into mixtures of 6-10 compounds for screening (K. A. Farley et al., SMASH'99, Argonne, IL, 15-18 August 1999).

Compounds chosen for our diversity library are lead-like as opposed to drug-like. It is often the case that chemical elaborations to improve affinity also increase molecular weight and decrease solubility (S. J. Teague et al., Angew. Chem. Int. Ed., 38, 3743 (1999)). The molecular weight of the compounds therefore should not exceed about 350. Since most hits obtained will have affinities for their target in the approximately 100 µM range, low molecular weight will leave room for chemical elaboration to build in more affinity and selectivity. Using larger molecular weight drug-like compounds would not substantially improve affinity of the hits and could easily preclude obtaining lead chemical templates of reasonable size. Lead-like hits that are reasonably water soluble allow for chemical elaboration that results in modest increased lipophilicity of the final therapeutic entity (S. J. Teague et al., Angew. Chem. Int. Ed., 38, 3743 (1999)). Water solubility is also important since it enhances the potential success of downstream studies such as calorimetry, enzymology, co-crystallization and NMR structural studies. Compound solubility is especially important for flow-injection NMR methods in order to prevent clogging of the capillary lines.

Compounds should also be chosen with their suitability for chemical elaboration by traditional or combinatorial chemistry methods in mind. Hits with facile handles for synthetic chemistry will be of more interest and will allow more efficient use of often limited medicinal chemistry resources.

### Relaxation-Edited or WaterLOGSY-Based Flow-Injection NMR Screening Methods

Calibration and validation of the flow system and creation of a small-molecule screening library yields an automated system that is ready to screen new targets. A protein target can be analyzed for protein-ligand interactions using relaxation-editing methods by adding sufficient protein to each well of the 96-well library plate to give a 1:1 (protein:ligand) ratio at a concentration of approximately 50 µM. Homogeneous sample dispersion throughout the well can be facilitated by agitating the plate on a flat bed shaker. Screening at this concentration allows a decent 1D ¹H NMR spectrum to be acquired in about 10 minutes. In our experience, this concentration of target and small molecule requires identified ligands to have affinities on the order of approximately 200 µM or tighter.

Once the screening plate has been prepared, the Gilson liquid sample handler transfers samples from 96-well plates into the flow-injection probe and if desired, returns the samples back into either the original 96-well plate or a new plate. Once the sample is in the magnet, spectra that can detect changes in chemical shifts, relaxation properties, or diffusion properties can be collected.

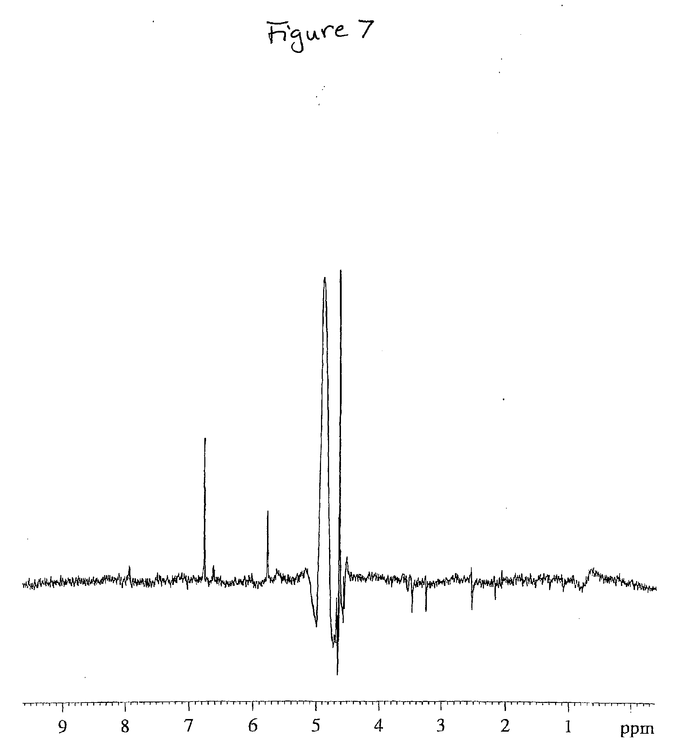

Binding is detected using the WaterLOGSY technique. Extremely low levels of target are used (1-10 µM) with ratios of ligand to target of 100:1 1 to 10:1. For data analysis, binding compounds are distinguished from nonbinders by the opposite sign of their water-ligand NOEs. In contrast to a relaxation-edited technique, only a single WaterLOGSY spectrum is used for each ligand mixture. There is no need to collect a reference spectrum in the absence of target protein. An example is illustrated in Figure 7 for a mixture of compounds and a different protein. In the WaterLOGSY spectrum shown in Figure 7, binding compounds have resonances of opposite intensity (sharp positive peaks) than nonbinders (near zero intensity or sharp negative peaks). Residual protein resonances are also of positive intensity.

### Data Analysis

The development of flow probes has facilitated the transition to high-throughput NMR and has made possible the routine collection of tremendous volumes of data. Recent software developments have advanced the automated handling of large data sets collected on combinatorial chemistry libraries (P. A. Keifer et al., J. Comb. Chem., 2, 151 (2000); Bruker Instruments, AMIX, BEST and ICONNMR software packages; Varian NMR Systems, VNMR software package; and Williams A, Book of Abstracts, 218th ACS National Meeting (1999)). Visualization of results in a 96-well format allows rapid evaluation of the data sets. The integration of features such as this into a software package tailored more for data reduction and evaluation of library screening data sets parallels the combinatorial chemistry software development but remains slightly behind. However, recent advancements that have been made for combinatorial chemistry data analyses portend similar developments for the automation of protein binding screening data.

In our WaterLOGSY data sets, binding compounds are distinguished from nonbinders by the opposite sign of their water-ligand NOEs, as observed in Figure 7. Comparison to an assigned small molecule control spectrum is made, to identify the compound associated with the indicated resonances.

Other labs have relied on difference spectra to analyze relaxation- or diffusion-edited 1D ¹H NMR data sets (P. J. Hajduk et al., J. Am. Chem. Soc., 119, 12257 (1997); N. Gonnella et al., J. Magn. Reson., 131, 336 (1998); and A. Chen et al., J. Am. Chem. Soc., 122, 414 (2000)). After a series of spectral subtractions, the resulting spectrum represents the resonances of the compounds that bind to the protein. Two factors that pose problems are line broadening and shifting resonances, both of which can lead to subtraction artifacts. Changes in intensity can also add the need for a scaling factor in the data analysis step. These additional steps, which can vary from one spectrum to the next, make strategies for automated data analysis complex.

Data analysis for 2D screening methods typically involves either the analysis of protein chemical shift perturbations indicative of ligand binding (A. Ross et al., J. Biomol. NMR, 16, 139 (2000); and S. B. Shuker et al, Science, 274, 1531 (1996)), or the analysis of changes in signals from the small molecules in NOE or DECODES spectra indicative of binding (B. Meyer et al., Eur. J. Biochem., 246, 705 (1997); J. Fejzo et al., Chem. Biol., 6, 755 (1999); and M. Lin et al., J. Am. Chem. Soc., 119, 5249 (1997)). While a series of 2D ¹H-¹⁵N HSQC spectra can be compared manually, automated analysis using both non-statistical and statistical approaches of a series of ¹H-¹⁵N HSQC spectra acquired with flow-injection NMR methods was recently demonstrated (A. Ross et al., J. Biomol. NMR, 16, 139 (2000)). AMIX was used for the non-statistical analysis by comparing spectra collected in the presence of single compounds to the reference spectrum of the protein alone. Then, using bucketing calculations for data reduction, a table ranked by the correlation coefficient was generated. No correlations were observed using the bucketing calculations alone. Subsequently, integration patterns for all 300 small molecule spectra were analyzed by AMIX to generate a data matrix of N integration regions times 300. A statistical software package, UNSCRAMBLER 6.0, was then used to analyze this data matrix using principal components analysis. Two classes of spectral changes were observed. Ultimately, one class was found to correspond to pH changes caused by certain small molecules while the other class corresponded to small molecules binding to the target protein (A. Ross et al., J. Biomol. NMR, 16, 139 (2000)).

Data reduction is an important aspect for handling the amounts of data generated if high-throughput screening by NMR is to be successful. Non-statistical methods such as the bucketing calculations of AMIX (Bruker Instruments, AMIX, BEST and ICONNMR software packages) or the database comparisons of ACD (Williams A, Book of Abstracts, 218th ACS National Meeting (1999)) compare chemical shift, multiplicity, integration regions and patterns to give correlation factors between spectra. These software packages can be used for data reduction of both one- and two-dimensional data. Prediction software is also available to help aid in interpretation of data sets. Statistical methods such as principal components analysis can be used to analyze data for other correlations that are not apparent using non-statistical methods alone. In the case of 2D ¹H-¹⁵N HSQC data, an adaptive, multivariate method that incorporates a weighted mapping of perturbations to correlate information within a spectrum or across many spectra has also been described (F. Delaglio, CHI Conference on NMR Technologies: Development and Applications for Drug Discovery, Baltimore, MD, 4-5 November 1999).

### Comparison of Flow vs. Traditional Methods

The advantage of working with samples in the flow NMR screening environment is that each set of spectra is collected on samples that are at the same concentration. This accelerates spectral acquisition considerably. Since the samples are fairly homogeneous, many of the routine tasks need to be completed on only the first sample: probe tuning, ¹H 90° pulse calibration, receiver gain, number of transients, locking, and gradient shimming. On subsequent samples, these steps can be omitted, although simplex shimming of Z₁ and Z₂ can still be used with multi-day acquisitions.

Prerequisites for a high-throughput assay include rapid data collection, sample-to-sample integrity and minimal costs. Flow NMR techniques have been developed with each in mind. For 1D ¹H NMR screening experiments, the process of removing the previous sample from the flow cell, rinsing the flow cell, injecting the next sample, allowing for thermal equilibration, automating solvent suppression and acquiring the data can take less than 10 minutes. In practice, the use of this procedure is two to three times faster than a sample changer with conventional NMR tubes. If compounds were screened in mixtures of 10, this results in a throughput of about 1,500 compounds per day. Use of a liquid handler, such as the Gilson 215 typically employed by Bruker and Varian flow NMR systems, can simplify the preparation of samples as well. Ross and coworkers have demonstrated on-the-fly sample preparation by using the liquid handler to mix the protein to be screened with the small molecule immediately prior to injection (A. Ross et al., J. Biomol. NMR, 16, 139 (2000)). Sample conditions can thus be highly standardized with the resulting spectra very consistent and reproducible. Even if target protein is added manually to pre-plated screening libraries, the amount of pipetting is still less than if using NMR tubes. Recurring expenses associated with purchasing and/or cleaning NMR tubes are eliminated with flow-injection NMR methods. The cost of the 96-well microtitre plates is insignificant compared to NMR tubes.

## Claims

1. A method of identifying a compound that binds to a target molecule, the method comprising:
selecting a library of test compounds each having a solubility in deuterated water of at least 1 mM at room temperature and a molecular weight of no greater than 350 grams/mole;
providing a plurality of mixtures of the test compounds, each mixture being in a sample reservoir;
introducing a target molecule into each sample reservoir, to provide a plurality of test samples;
providing a nuclear magnetic resonance spectrometer equipped with a flow-injection probe;
transferring each test sample from the sample reservoir into the flow-injection probe;
collecting a WaterLOGSY nuclear magnetic resonance spectrum on each sample in each reservoir; and
analysing the spectrum of each sample, to distinguish binding compounds from non-binding compounds, by virtue of the opposite signs of their water-ligand nuclear Overhauser effects;
wherein the concentration of target molecule and each test compound in each sample reservoir is no greater than 100 µM, and wherein the ratio of target molecule to each test compound in each sample reservoir is no more than 1:1.

2. The method of claim 1, wherein the said ratio is 1:100 to 1:10.

3. The method of claim 1 or claim 2, wherein the concentration of target molecule and each compound in each sample is at least 25 µM.

4. The method of any preceding claim, wherein the concentration of target molecule and each compound in each sample is no greater than 50 µM.

5. The method of any preceding claim, wherein each mixture is in a sample reservoir of a multiwell sample holder.

6. The method of claim 5, wherein the multiwell sample holder is a 96-well microtiter plate.

7. The method of any preceding claim, wherein each test compound has a molecular weight of no greater than 325 grams/mole.

8. The method of any preceding claim, wherein each mixture of compounds comprises at least 3 compounds, each compound having at least one distinguishable resonance in a 1D NMR spectrum of the mixture.

9. The method of claim 8, wherein each mixture comprises at least 6 compounds.

10. The method of any preceding claim, wherein the dissociation constant of a compound that binds to the target molecule is at least 100 µM.

11. The method of any preceding claim, wherein the target molecule is a protein.

## Patentansprüche

1. Verfahren zum Identifizieren einer Verbindung, die sich an ein Zielmolekül bindet, wobei das Verfahren umfasst:
Auswählen einer Bibliothek von Testverbindungen, von denen jede eine Löslichkeit in deuteriertem Wasser von wenigstens 1 mM bei Raumtemperatur und ein Molekulargewicht von nicht größer als 350 Gramm/Mol aufweist;
Bereitstellen einer Vielzahl von Mischungen der Testverbindungen, wobei jede Mischung in einem Probenreservoir ist;
Einführen eines Zielmoleküls in jedes Probenreservoir, um eine Vielzahl von Testproben bereitzustellen;
Bereitstellen eines Kernspinresonanzspektrometers, das mit einer Fließinjektionssonde ausgestattet ist;
Übertragen jeder Testprobe von dem Probenreservoir in die Fließinjektionssonde;
Erfassen eines WaterLOGSY-Kernspinresonanzspektrums auf jeder Probe in jedem Reservoir; und
Analysieren des Spektrums jeder Probe, um bindende Verbindungen von nichtbindenden Verbindungen aufgrund entgegengesetzter Vorzeichen ihrer Wasser-Ligand-Kern-Overhauser-Effekte zu unterscheiden;
wobei die Konzentration von Zielmolekül und jeder Testverbindung in jedem Probenreservoir nicht größer als 100 µM ist, und wobei das Verhältnis von Zielmolekül zu jeder Testverbindung in jedem Probenreservoir nicht mehr als 1:1 ist.

2. Verfahren gemäß Anspruch 1, wobei das Verhältnis 1:100 bis 1:10 ist.

3. Verfahren gemäß Anspruch 1 oder Anspruch 2, wobei die Konzentration von Zielmolekül und jeder Verbindung in jeder Probe wenigstens 25 µM ist.

4. Verfahren gemäß einem der vorhergehenden Ansprüche, wobei die Konzentration von Zielmolekül und jeder Verbindung in jeder Probe nicht größer als 50 µM ist.

5. Verfahren gemäß einem der vorhergehenden Ansprüche, wobei jede Mischung in einem Probenreservoir eines Multiwell-Probenhalters ist.

6. Verfahren gemäß Anspruch 5, wobei der Multiwell-Probenhalter eine 96-Well-Mikrotiterplatte ist.

7. Verfahren gemäß einem der vorhergehenden Ansprüche, wobei jede Testverbindung ein Molekulargewicht von nicht größer als 325 Gramm/Mol aufweist.

8. Verfahren gemäß einem der vorhergehenden Ansprüche, wobei jede Mischung von Verbindungen wenigstens 3 Verbindungen umfasst, wobei jede Verbindung wenigstens eine unterscheidbare Resonanz in einem 1 D-NMR-Spektrum der Mischung aufweist.

9. Verfahren gemäß Anspruch 8, wobei jede Mischung wenigstens 6 Verbindungen umfasst.

10. Verfahren gemäß einem der vorhergehenden Ansprüche, wobei die Dissoziationskonstante einer Verbindung, die sich an das Zielmolekül bindet, wenigstens 100 µM ist.

11. Verfahren gemäß einem der vorhergehenden Ansprüche, wobei das Zielmolekül ein Protein ist.

## Revendications

1. Procédé d'identification d'un composé qui se lie à une molécule cible, le procédé comprenant les étapes consistant à :
choisir une collection de composés de test présentant chacun une solubilité dans l'eau deutériée d'au moins 1 mM à température ambiante, et une masse moléculaire pas supérieure à 350 grammes/mole ;
prévoir plusieurs mélanges des composés d'essai, chaque mélange se trouvant dans un réservoir à échantillon ;
introduire une molécule cible dans chaque réservoir à échantillon, pour fournir plusieurs échantillons d'essai ;
prévoir un spectromètre à résonance magnétique nucléaire équipé d'une sonde d'injection à écoulement ;
transférer chaque échantillon de test du réservoir à échantillon dans la sonde d'injection à écoulement ;
recueillir un spectre de résonance magnétique nucléaire WaterLOGSY pour chaque échantillon dans chaque réservoir ; et
analyser le spectre de chaque échantillon pour distinguer des composés qui se lient de composés qui ne se lient pas, du fait de signes opposés de leurs effets Overhauser nucléaires ligand -eau ;
dans lequel la concentration de la molécule cible et de chaque composé de test dans chaque réservoir à échantillon n'est pas supérieure à 100 µM, et la proportion de la molécule cible par rapport à chaque composé d'essai dans chaque échantillon n'est pas supérieure à 1:1.

2. Procédé selon la revendication 1, dans lequel ladite proportion est de 1:100 à 1:10.

3. Procédé selon la revendication 1 ou la revendication 2, dans lequel la concentration de la molécule cible et de chaque composé dans chaque échantillon est d'au moins 25 µM.

4. Procédé selon l'une quelconque des revendications précédentes, dans lequel la concentration de la molécule cible et de chaque composé dans chaque échantillon n'est pas supérieure à 50 µM.

5. Procédé selon l'une quelconque des revendications précédentes, dans lequel chaque mélange se trouve dans un réservoir à échantillon d'un porte-échantillons à puits multiples.

6. Procédé selon la revendication 5, dans lequel le porte échantillons à puits multiples est une plaque de microtitration à 96 puits.

7. Procédé selon l'une quelconque des revendications précédentes, dans lequel chaque composé de test présente une masse moléculaire non supérieure à 325 grammes/mole.

8. Procédé selon l'une quelconque des revendications précédentes, dans lequel chaque mélange de composés compte au moins 3 composés, chaque composé présentant au moins une résonance distinctive dans un spectre de résonance magnétique nucléaire 1D du mélange.

9. Procédé selon la revendication 8, dans lequel chaque mélange compte au moins 6 composés.

10. Procédé selon l'une quelconque des revendications précédentes, dans lequel la constante de dissociation d'un composé qui se lie à la molécule cible est d'au moins 100 µM.

11. Procédé selon l'une quelconque des revendications précédentes, dans lequel la molécule cible est une protéine.
